Europäisches Patentamt

European Patent Office

Office européen des brevets

(19)

(11) Veröffentlichungsnummer : **0 061 059**
**B1**

(12)                     **EUROPÄISCHE PATENTSCHRIFT**

(45) Veröffentlichungstag der Patentschrift :
22.01.86

(21) Anmeldenummer : **82101818.1**

(22) Anmeldetag : **08.03.82**

(51) Int. Cl.⁴ : **G 03 F  7/08**, G 03 F  7/02,
**B 41 N  3/00**

(54) **Verfahren zum Einbrennen von lichtempfindlichen Schichten bei der Herstellung von Druckformen.**

(30) Priorität : **19.03.81 DE 3110632**

(43) Veröffentlichungstag der Anmeldung :
**29.09.82 Patentblatt 82/39**

(45) Bekanntmachung des Hinweises auf die Patenterteilung : **22.01.86 Patentblatt 86/04**

(84) Benannte Vertragsstaaten :
**AT BE CH DE FR GB IT LI NL SE**

(56) Entgegenhaltungen :
**AT-B-  321 958
DE-B- 1 955 378
ABC des Optik, K. Mütze, Verlag Werner Dausien
1966, Hanau, S. 528, 529**

(73) Patentinhaber : **HOECHST AKTIENGESELLSCHAFT
Postfach 80 03 20
D-6230 Frankfurt am Main 80 (DE)**

(72) Erfinder : **Berghäuser, Günter
Schönaustrasse 58
D-6200 Wiesbaden (DE)**

**Beschreibung**

Die Erfindung betrifft ein Verfahren zum Einbrennen von belichteten und entwickelten, positiv arbeitenden, Diazoverbindungen enthaltenden lichtempfindlichen Schichten während der Herstellung von Offsetdruckformen durch Erhitzen der Druckplatte mit einem Infrarot-Anteil und einen im Sichtbaren liegenden Anteil aufweisender elektromagnetischer Strahlung auf mindestens 180 °C. Bei positiv arbeitenden lichtempfindlichen Schichten werden die während der bildmäßigen Belichtung der Druckplatte vom Licht getroffenen Teile der lichtempfindlichen Schicht relativ löslicher als die nicht vom Licht getroffenen Teile. Durch das Herauslösen der erstgenannten Teile im Entwicklungsschritt entstehen auf der Druckplattenoberfläche nach dem Entwickeln der belichteten Schicht die beim Drucken wasserführenden Nichtbildstellen der späteren Druckform und aus den letztgenannten Teilen die beim Drucken farbführenden Bildstellen. In der Praxis hat sich herausgestellt, daß eine Erhitzung der belichteten und entwickelten Druckplatte — je nach Art des Trägermaterials auf Temperaturen von etwa 180 °C und mehr — von der Seite der lichtempfindlichen Schicht oder auch von der Rückseite her zu höheren Druckauflagen führen kann ; dieser Vorgang wird als « Einbrennen » bezeichnet. Man nimmt an, daß dafür u. a. zwei Faktoren ausschlaggebend sind : Einerseits findet eine mechanische Verfestigung der Bildstellen statt, so daß diese beim Lagern und Drucken, etwa durch Lichteinwirkung, weniger leicht beschädigt werden können ; andererseits werden die Bildstellen auch gegenüber chemischen oder physikalisch-chemischen Angriffen resistenter, was sich beispielsweise darin äußert, daß sie von organische Lösemittel enthaltenden Druckfarben oder von Ätzmedien weniger leicht angegriffen werden als nicht-eingebrannte Bildstellen.

Aus dem Stand der Technik sind beispielsweise die folgenden Verfahren und/oder Vorichtungen zum Einbrennen von lichtempfindlchen Schichten bekannt geworden :

In der DE-B-854 890 (= US-A-3 046 121) wird die Nachbehandlung von positiv arbeitenden, Diazoverbindungen enthaltenden lichtempfindlichen Schichten durch Erhitzen der diese Schichten aufweisenden Druckplatten beschrieben. Das Erhitzen wird vor oder nach der Entwicklung der belichteten Druckplatte durch Behandlung mit Flammen, mit einem heißen Bügeleisen, in einem elektrisch auf höhere Temperaturen geheizten Kasten oder zwischen geheizten Walzen bewirkt ; die unbelichtete Diazoverbindung soll durch das Erhitzen zersetzt, und das Zersetzungsprodukt fest mit dem Trägermaterial verbunden werden.

Aus der DE-B-14 47 963 (= GB-A-1 154 749) ist ein Verfahren zum Herstellen einer Offsetdruckform bekannt, bei dem die Druckplatten mit positiv arbeitenden, o-Naphthochinondiazidverbindungen enthaltenden lichtempfindlichen Schichten nach dem Entwickeln in Gegenwart eines Novolaks und/oder eines Resols auf eine Temperatur von mindestens 180 °C erhitzt werden. Das Harz ist entweder bereits in der lichtempfindlichen Schicht vorhanden oder wird vor dem Erhitzen in Lösung auf die lichtempflindliche Schicht aufgebracht. Die Höhe der Erhitzungstemperatur und die Erhitzungsdauer werden so gewählt, daß durch Zersetzen der farbführenden (nicht vom Licht getroffenen) Bildstellen ein Niederschlag auf den beim Drucken wasserführenden (durch den Entwickler entfernten, vom Licht getroffenen) Teilen der Druckplatte entsteht ; durch eine Nachbehandlung werden dann diese beim Drucken wasserführenden Teile der Druckplatte wieder gesäubert. Die Erhitzungstemperatur soll insbesondere bei 200° bis 250 °C liegen, die zugehörige Erhitzungsdauer beträgt dann 5 bis 60 min ; die Erhitzung wird in einem Einbrennofen durchgeführt.

Die Vorrichtung zum Einbrennen von Druckplatten mit einer belichteten und entwickelten Diazoschicht gemäß der DE-B-19 55 378 (= GB-A-1 330 139) arbeitet bei einer Erhitzungstemperatur von mindestens 180 °C und enthält als Erhitzungselement eine Quarz-Halogen-Lampe mit einem im sichtbaren Spektralbereich liegenden Strahlungsanteil von 10 bis 15 %. Diese Quarz-Halogen-Lampen sollen sich gegenüber Wärmeschränken oder Infrarot(IR)-Heizstäben durch eine relativ kurze Aufheizzeit auszeichnen. Verglichen mit IR-Heizstäben haben sie einen erheblich höheren Strahlungsanteil im sichtbaren Spektralbereich.

Beim Verfahren zur Herstellung von Flachdruckformen nach der DE-A-22 01 936 (= GB-A-1 413 374) werden die belichteten und entwickelten lichtempfindlichen Schichten von der Rückseite der Druckplatte her mit IR-Strahlung erwärmt, wobei diese Rückseite eine IR-absorbierende Schicht trägt.

In dem DE-U-69 01 603 (= US-A-3 589 261) wird eine Vorrichtung zum Entwickeln von negativarbeitenden, fotopolymerisierbare Verbindungen enthaltenden lichtempfindlichen Schichten auf flexiblen Trägermaterialien beschrieben, die auch (Seite 3, Absatz 4 ; Seite 5, Absatz 1 ; Seite 9, Absatz 4 und Seite 10) eine Nachbelichtungsstufe umfaßt, wobei UV (Ultraviolett)- und IR-Licht abstrahlende Lampen zum Einsatz kommen. In dieser Stufe soll einerseits das Material nach der Hauptentwicklungsstufe getrocknet werden und andererseits eine Nachbelichtung der verbliebenen fotopolymerisierbaren Anteile in den Bildstellen stattfinden.

Aus den DE-U-72 02 150 und DE-U-78 05 619 ist es bekannt, daß in der Praxis im wesentlichen drei Arten von Einbrennschränken für Druckplatten eingesetzt werden, nämlich horizontal oder vertikal arbeitende Umluft-Einbrennschränke oder vertikal arbeitende Einbrennöfen mit Erhitzungseinrichtungen auf der Basis elektromagnetischer Strahlung ; auch eine Erhitzung der lichtempfindlichen Schicht über das Auflegen der Druckplatten auf einen beheizten Zylinder ist möglich.

Die aus dem Stand der Technik bekanntgewordenen Einbrennverfahren weisen aber folgende Nachteile auf ;

Die Verfahren, die mit offener Flamme arbeiten, oder bei denen beheizte Walzen verwendet werden, sind hinsichtlich der erzeugten Temperatur nur ungenügend reproduzierbar, können zur Beschädigung von Teilen der Druckplatten führen und gestatten kein gleichmäßiges Einbrennen der Schicht.

Die Verfahren, bei denen in einem Wärmeschrank beispeilsweise mit erwärmter Umluft gearbeitet wird, führen zwar zu einer besser-reproduzierbaren Temperatureinstellung und zu einer Vergleichmäßigung des Einbrennens, es müssen jedoch lange Aufheizzeiten vor und während des Einbrennens in Kauf genommen werden und es kann, insbesondere bei Druckplatten-Trägermaterialien auf der Basis organischer Polymerer oder aus Aluminium, zu einer negativen Beeinflussung der mechanischen Festigkeit (z. B. der Zugfestigkeit) der Trägermaterialien kommen.

Die Verfahren, bei denen elektromagnetische Strahlung mit einem ausschließlichen oder sehr hohen IR-Anteil eingesetzt wird, können zwar, insbesondere bei einer Reduzierung des Abstands zwischen lichtempfindlicher Schicht und Wärmequelle, zu einer Reduktion der Behandlungszeit von mindestens 5 bis 6 min in sogenannten Einbrennschränken auf beispielsweise etwa 1 min führen, sie haben dann jedoch die unerwünschte Nebenwirkung einer sehr starken negativen Beeinflussung der mechanischen Festigkeit der Druckplatten-Trägermaterialien.

Es war zwar bereits von der Aufarbeitung von belichteten und entwickelten, negativ arbeitenden Druckplatten mit fotopolymerisierbaren Verbindungen in der lichtempfindlichen Schicht her bekannt, diese mit UV- und IR-Licht abstrahlenden Lampen in einer « Nachbelichtungsstufe » zu bestrahlen, aber eine solche Maßnahme sollte anderen Zwecken dienen und führt damit auch eher vom vorliegenden Erfindungsgegenstand weg. Diese Lampen sollen nämlich einerseits zur Materialtrocknung und andererseits zur Nachbelichtung von noch in den Bildstellen verbliebenen fotopolymerisierbaren Anteilen dienen ; d. h. da bei negativ arbeitenden lichtempfindlichen Schichten die vom Licht getroffen Teile der Schicht weniger löslich werden, soll die Bestrahlung mit den, einen UV-Anteil aufweisenden Lampen zu einer vollständigen Unlöslichmachung solcher Bildstellen oder Teile von Bildstellen (z. B. in den eher der Oberfläche des Trägermaterials benachbarten Bereichen, die weiter von der Lichtquelle in der eigentlichen Belichtungsstufe entfernt waren) führen, die dies noch nicht oder nur ungenügend sind. Damit ist aber eine überlegungsfreie Übertragung dieser Lehre auf das Einbrennen von positiv arbeitenden lichtempfindlichen Schichten nicht möglich, da dort genau entgegengesetzte Voraussetzungen herrschen, d. h. man mußte zunächst davon ausgehen, daß eine Bestrahlung mit UV-Licht zu einer größeren Löslichkeit der von Licht getroffenen Schichtteile führen mußte.

Aufgabe der vorliegenden Erfindung ist es, ein Verfahren zum Einbrennen von positiv arbeitenden lichtempfindlichen Schichten auf Druckplatten vorzuschlagen, das in kurzer Zeit durchführbar ist, zu gleichmäßig beeinflußten Bildstellen in den Schichten führt und die mechanischen Eigenschaften des Trägermaterials der Druckplatten, insbesondere von Trägermaterialien auf der Basis von Aluminium, nur in einer für das Anwendungsgebiet zumutbaren Weise beeinflußt.

Die Erfindung geht aus von dem bekannten Verfahren zum Einbrennen von belichteten und entwickelten, positiv arbeitenden, Diazoverbindungen enthaltenden lichtempfindlichen Schichten während der Herstellung von Offsetdruckformen durch Erhitzen der Druckplatte mit einen Infrarot-Anteil und einen im Sichtbaren liegenden Anteil aufweisender elektromagnetischer Strahlung auf wenigstens 180 °C. Das erfindungsgemäße Verfahren ist dann dadurch gekennzeichnet, daß die elektromagnetische Strahlung einen Infrarot-Anteil von 50-87 %, einen im Sichtbaren liegenden Anteil von 10 bis 30 % und einen Ultraviolett-Anteil von 3 bis 20 % aufweist.

Das erfindungsgemäße Verfahren läßt sich grundsätzlich für jede Offsetdruckplatte anwenden, die in der positiv arbeitenden lichtempfindlichen Schicht mindestens eine Diazoverbindung als lichtempfindliche Komponente enthält, insbesondere sind diese Verbindungen Ester oder Amide von o-Naphthochinondiazidsulfonsäuren oder o-Naphthochinondiazidcarbonsäuren (siehe beispielsweise die bereits eingangs erwähnte DE-B-14 47 963). Neben der Diazoverbindungs-Komponente enthalten die lichtempfindlichen Schichten normalerweise auch ein Harz, insbesondere einen Novolak und/oder ein Resol, es können aber auch verschiedene weitere Komponenten wie Farbstoffe oder Haftvermittler vorhanden sein.

Als Trägermaterialien für die lichtempfindlichen Schichten können die in der Offsetdrucktechnik üblichen verwendet werden. Dazu zählen, neben den für Einbrennverfahren wegen ihrer im allgemeinen ungenügend temperaturstabilen Zusammensetzung weniger geeigneten Folien aus organischen Polymeren wie Polyestern, insbesondere Metallfolien auf der Basis von Aluminium, Zink oder Stahl ; bevorzugt werden Aluminiumplatten eingesetzt, die chemisch, mechanisch oder elektrochemisch aufgerauht sind und gegebenenfalls noch eine Aluminiumoxidschicht tragen. Oftmals wird das Druckplattenträgermaterial auch noch auf der Oberfläche vor dem Aufbringen der lichtempfindlichen Schicht modifiziert, beispielsweise mit wäßrigen Polyvinylphosphonsäure- oder Natriumsilikatlösungen.

In der Praxis des Einbrennens können vor und/oder nach dem thermischen Behandlungsschritt auch noch verschiedenste Hilfsmittel zum Einsatz kommen, dazu zählen beispielsweise :

wäßrige Fluorwasserstoffsäure, wäßrige Trinatriumphosphatlösung, wäßrige Phosphorsäure oder wäßrige Borfluorwasserstoffsäure zur Entfernung der beim Einbrennen entstehenden Verunreinigungen an den Nichtbildstellen der Druckplatte bzw. wäßrige Phosphorsäure zur Hydrophilierung der Nichtbildstellen vor dem Einbrennen gemäß der DE-B-14 47 963 (= GB-A-1 154 749),

3

wäßrige Lösungen von wasserlöslichen organischen Substanzen wie Gummi arabicum, Celluloseether, Polyacrylsäure, Salze organischer Säuren oder anionogene Tenside wie Alkylarylsulfonate und/oder von wasserlöslichen anorganischen Salzen wie Halogenide, Borate, Phosphate oder Sulfate zur Modifizierung der gesamten Plattenoberfläche (mit besonderer hydrophilierender Wirkung auf die Nichtbildstellen) vor dem Einbrennen gemäß der DE-A-26 26 473 (= GB-A-1 555 233),

eine wäßrige Lösung von Polyvinylphosphonsäure zur Entfernung der beim Einbrennen entstehenden Verunreinigungen an den Nichtbildstellen der Druckplatte gemäß der DE-A-28 55 393.

Die im erfindungsgemäßen Verfahren einzusetzende elektromagnetische Strahlung kann mit solchen herkömmlichen Lampen mit einem UV-Anteil erzeugt werden, wie sie sonst zur Belichtung von lichtempfindlichen Schichten auf Druckplatten oder von Fotoresists verwendet werden. Ähnliche Lampen finden auch in Einrichtungen zur künstlichen Erzeugung von Hautbräune z. B. in Bräunungsstudios oder « Heimsonnen » Verwendung.

Zum UV-Bereich sollen dabei Wellenlängen bis etwa 380 nm und zum IR-Bereich Wellenlängen ab etwa 700 nm gezählt werden. Dafür geeignete Lampen sind insbesondere Quecksilberdampflampen, die auch noch einen gewissen Anteil an Metallhalogeniden wie Eisenjodid oder Galliumjodid enthalten können. Der angegebene Bereich für den IR-Anteil bezieht sich auf luftgekühlte Lampen, bei beispielsweise wassergekühlten Lampen sinkt der IR-Anteil signifikant.

Die normalerweise bei den handelsüblichen Quecksilberdampflampen auftretenden Verluste durch Konvektion und/oder Konduktion wurden bei den angegebenen Anteilsverhältnissen dem IR-Anteil zugeschlagen. Diese Verluste können in der Größenordnung von etwa 12 bis 30 % liegen.

Das Verfahren kann kontinuierlich oder auch diskontinuierlich durchgeführt werden, wobei die belichtete und entwickelte Schicht während des Einbrennens zweckmäßig äquidistant zur elektromagnetischen Strahlungsquelle angeordnet wird oder äquidistant an dieser vorbei bewegt wird und die Druckplatte von der Schichtseite her bestrahlt wird, um die thermische Belastung des Schichtträgers möglichst gering zu halten. Die Plattenrückseite kann sogar mit einer gekühlten Unterlage in Kontakt gebracht werden. Eine bessere Ausnutzung der eingestrahlten Energie findet jedoch ohne Wärmeabfuhr an der Rückseite statt, indem die Druckplatte relativ freihängend oder freiliegend befestigt, oder thermisch isoliert aufgelegt oder aufgehängt wird.

In einer bevorzugten Ausführungsform des erfindungsgemäßen Verfahrens läßt man die elektromagnetische Strahlung gleichzeitig und gleichmäßig über die gesamte Fläche der belichteten und entwickelten Schicht einwirken, um so ein besonders gleichmäßiges Einbrennen aller Bildstellen der Druckplatte und einen möglichst hohen thermischen Wirkungsgrad zu erzielen.

Eine noch bessere Ausnutzung der eingestrahlten Wärmeenergie läßt sich erreichen, wenn man die Absorptionsfähigkeit der belichteten und entwickelten Schicht für IR-Strahlung durch Zusatz eines Absorptionshilfsmittels erhöht.

Mit dem erfindungsgemäßen Verfahren lassen nich überraschend positiv arbeitende lichtempfindliche Schichten in verhältnismäßig kurzer Zeit gleichmäßig einbrennen, ohne daß dabei die mechanischen Eigenschaften der Trägermaterialien dieser Schichten in größerem Maße negativ zu beeinflußt werden. Dies gelingt bereits bei Einwirkungszeiten der Strahlung — je nach Abstand von der Strahlungsquelle, der Art der Beschichtung und des Trägermaterials oder der Art der Aufhängung oder Auflage — von etwa 15 bis 90 sec.

In den folgenden Beispielen verhalten sich Gew.-Teile zu Vol.-Teilen wie g zu cm$^3$, die Prozentangaben sind solche in Gew.-%. Es werden Druckplatten des folgenden Aufbaus eingesetzt :

Druckplatte Typ 1

Eine mechanisch aufgerauhte Aluminiumfolie wird unter Verwendung einer rotierenden Unterlage zum Abschleudern der überschüssigen Menge der aufgebrachten Lösung mit einer Lösung aus

1,5 Gew.-Teilen des Kondensationsproduktes aus 2,3,4-Trihydroxy-benzophenon und Naphthochinon-(1,2)-diazid-(2)-5-sulfochlorid,

0,8 Gew.-Teilen des Kondensationsproduktes aus 1 Mol 2,2'-Dihydroxy-1,1'-dinaphthylmethan und 2 Mol Naphthochinon-(1,2)-diazid-(2)-5-sulfochlorid,

0,6 Gew.-Teilen eines durch Kondensation eines technischen Kresolgemischs mit Formaldehyd hergestellten Novolaks vom Erweichungspunkt 108° bis 118 °C (nach DIN 53 181), und

120 Vol.-Teilen Ethylenglykolmonomethylether

beschichtet und zunächst in einem warmen Luftstrom und dann etwa 2 min bei 100 °C getrocknet. Die Belichtung der lichtempfindlichen Schicht kann unter einem Diapositiv mit einer Kohlenbogenlampe von 18 Ampere Stromstärke bei einem Lampenabstand von 70 cm während etwa 1 min erfolgen. Die belichtete Schicht wird durch Überwischen mit einem Wattebausch entwickelt, der in 5 %ige wäßrige Trinatriumphosphatlösung getaucht wird, danach wird mit Wasser gespült. Das Bild erscheint beim Entwickeln in leuchtend gelber Farbe auf metallischem Untergrund.

4

Druckplatte Typ 2

Eine elektrolytisch aufgerauhte und anodisch oxidierte Aluminiumfolie wird mit einer Lösung aus

2,17 Gew.-Teilen des 4-(2-Phenyl-prop-2-yl) phenolesters der Naphthochinon-(1,2)-diazid-(2)-4-sulfonsäure,

1,02 Gew.-Teilen des Kondensationsproduktes aus 1 Mol 2,2'-Dihydroxy-1,1'-dinaphthylmethan und 2 Mol Naphthochinon-(1,2)-diazid-(2)-5-sulfochlorid,

0,37 Gew.-Teilen Naphthochinon-(1,2)-diazid-(2)-4-sulfochlorid,

0,12 Gew.-Teilen Kristallviolett-Base,

9,90 Gew.-Teilen eines Kresol-Formaldehyd-Novolaks vom Erweichungsbereich 112° bis 118 °C (nach DIN 53 181),

43   Vol.-Teilen Tetrahydrofuran,

35   Vol.-Teilen Ethylenglykolmonomethylether, und

9   Vol.-Teilen Butylacetat

beschichtet. Die lichtempfindliche Schicht ist nach dem Trocknen kräftig-blau gefärbt und kann nach der Belichtung mit einer 20 %igen wäßrigen Lösung von $Na_2SiO_3 \cdot 9\ H_2O$ entwickelt werden.

Vergleichsbeispiel V 1

Je eine Druckplatet der Typen 1 und 2 wird auf eine Größe von 25 × 18 cm zugeschnitten, belichtet, entwickelt und während 5 bis 6 min in einem handelsüblichen Einbrennschrank (mit heißer Umluft) einer Temperatur von 240 °C ausgesetzt. Die Beständigkeit der eingebrannten Bildstellen der Druckform wird durch Einwirkenlassen eines Gemisches verschiedener organisches Lösemittel (auf der Basis von Acetanhydrid, Xylol und Dimethylformamid) geprüft. Bei der kürzeren Einbrennzeit sind die Bildstellen beider Druckplattentypen noch löslich, während von den während 6 min eingebrannten Proben die Bildstellen auch nach 5 min Einwirkzeit des Lösemittelgemisches nicht angelöst werden. Die Zugfestigkeit des Trägermaterials geht bei dieser Einbrennzeit von 166 N/mm² auf 139 N/mm² (Verlust von etwa 17 %) zurück.

Vergleichsbeispiel V 2

Je eine Druckplatte der Typen 1 und 2 wird die im Vergleichsbeispiel V 1 vorbehandelt und während 45 sec bzw. 60 sec in einem Abstand von 4 cm der Strahlung mehrerer handelsüblicher IR-Strahler ausgesetzt. Bei der Überprüfung der Beständigkeit der Bildstelen gemäß den Angaben im Vergleichsbeispiel V 1 werden die in der kürzeren Zeit eingebrannten Bildstellen noch aufgelöst, während die Bildstellen der während 60 sec eingebrannten Proben nicht mehr aufgelöst werden. Die Zugfestigkeit des Trägermaterials geht bei dieser Einbrennzeit von 167 N/mm² auf 78 N/mm² (Verlust von etwa 53 %) zurück, und das Trägermaterial ist für die Verwendung als Druckform nicht mehr gebrauchsfähig.

Beispiel 1

Je eine Druckplatte der Typen 1 und 2 wird wie im Vergleichsbeispiel V 1 vorbehandelt und während 25 sec bzw. 30 sec in einem Abstand von 25 cm der Strahlung einer als Bestrahlungslampe zur Belichtung von Druckplatten handelsüblichen 5 kW Quecksilberdampflampe (mit einem Gehalt an Galliumjodid) ausgesetzt. Die spektrale Verteilung dieser Lampe beträgt etwa : 11 % UV-Anteil, 19 % Anteil im Sichtbaren und 71 % IR-Anteil (davon 15 % Verlust). Bei der Überprüfung des Beständigkeit der Bildstellen gemäß den Angaben im Vergleichsbeispiel V 1 werden die in der kürzerer Zeit eingebrannten Bildstellen noch aufgelöst, während die Bildstellen der während 30 sec eingebrannten Proben nicht mehr aufgelöst werden. Die Zugfestigkeit des Trägermaterials geht auch nach 60 sec Einbrennzeit nur von 167 N/mm² auf 147 N/mm² (Verlust von etwa 12 %) zurück.

Beispiel 2

Eine Druckplatte des Typs 1 wird die im Vergleichsbeispiel V 1 vorbehandelt und die eine Hälfte während 8 min in einem handelsüblichen Einbrennschrank einer Temperatur von 230 °C ausgesetzt und die andere Hälfte während 30 sec in einem Abstand von 25 cm der Strahlung der im Beispiel 1 angegebenen Lampe. Von beiden Druckformen können auf einer handelsüblichen Druckmaschine mit einem Feuchtwerk, das mit einem Isopropanol/Wasser-Gemisch betrieben wird, etwa 80.000 gute Drucke erstellt werden, d. h. ein Einbrennen von positiv arbeitenden lichtempfindlichen Schichten nach dem erfindungsgemäßen Verfahren liefert mit signifikant kürzerer und das Trägermaterial schonender Einbrennzeit bei gleicher Schichtzusammensetzung vergleichbare Ergebnisse beim Drucken von diesen Schichten.

**Patentansprüche**

1. Verfahren zum Einbrennen von belichteten und entwickelten, positiv arbeitenden, Diazoverbindungen enthaltenden lichtempfindlichen Schichten während der Herstellung von Offsetdruckformen durch Erhitzen der Druckplatte mit einen Infrarot-Anteil und einen im Sichtbaren liegenden Anteil aufweisender elektromagnetischer Strahlung auf mindestens 180 °C, dadurch gekennzeichnet, daß die elektromagnetische Strahlung einen Infrarot-Anteil von 50 bis 87 %, einen im Sichtbaren liegenden Anteil von 10 bis 30 % und einen Ultraviolett-Anteil von 3 bis 20 % aufweist.

2. Verfahren nach Anspruch 1, dadurch gekennzeichnet, daß die belichtete und entwickelte Schicht während des Einbrennens äquidistant zur elektromagnetischen Strahlungsquelle angeordnet oder äquidistant an dieser vorbeibewegt wird und die Druckplatte von der Schichtseite her bestrahlt wird.

3. Verfahren nach einem der Ansprüche 1 bis 2, dadurch gekennzeichnet, daß die elektromagnetische Strahlung gleichzeitig und gleichmäßig über die gesamte Fläche der belichteten und entwickelten Schicht einwirkt.

4. Verfahren nach einem der Ansprüche 1 bis 3, dadurch gekennzeichnet, daß die der Strahlung abgewandte Seite thermisch isoliert wird.

5. Verfahren nach einem der Ansprüche 1 bis 4, dadurch gekennzeichnet, daß die Absorptionsfähigkeit der belichteten und entwickelten Schicht für Infrarot-Strahlung durch Zusatz eines Absorptionshilfsmittels erhöht wird.

**Claims**

1. A process for the baking of exposed and developed, positive-working, light-sensitive layers, containing diazo compounds, during the preparation of offset printing forms, by heating the printing plate to at least 180 °C by means of electromagnetic radiation which contains an infrared fraction and a fraction in the visible region, wherein the electromagnetic radiation contains an infrared fraction of 50 to 87 %, a fraction in the visible range of 10 to 30 % and an ultraviolet fraction of 3 to 20 %.

2. The process as claimed in claim 1, wherein, during baking the exposed and developed layer is arranged at a constant distance from the source of electromagnetic radiation, or is moved at a constant distance past the latter, and the printing plate is irradiated from the side carrying the layer.

3. The process as claimed in any of claims 1 or 2, wherein the electromagnetic radiation acts simultaneously and uniformly on the total surface area of the exposed and developed layer.

4. The process as claimed in any of claims 1 to 3, wherein the side facing away from the radiation is heat-insulated.

5. The process as claimed in any of claims 1 to 4, wherein the absorption capacity of the exposed and developed layer for infrared radiation is increased by the addition of an adsorption aid.

**Revendications**

1. Procédé pour la cuisson de couches sensibles à la lumière, contenant des composés diazoïques, travaillant en positif, exposées et développées, pendant la préparation de formes pour impression offset, par chauffage de la plaque d'impression à au moins 180 °C avec un rayonnement électromagnétique ayant une fraction infrarouge et une fraction dans la région visible, procédé caractérisé en ce que le rayonnement électromagnétique a une fraction infrarouge de 50 à 87 %, une fraction dans la région visible de 10 à 30 % et une fraction ultraviolette de 3 à 20 %.

2. Procédé selon la revendication 1, caractérisé en ce que la couche exposée et développée est disposée pendant la cuisson à équidistance de la source de rayonnement électromagnétique ou est déplacée à équidistance de celle-ci et la plaque d'impression est irradiée du côté de la couche.

3. Procédé selon l'une des revendications 1 et 2, caractérisé en ce que le rayonnement électromagnétique agit simultanément et uniformément sur toute la surface de la couche exposée et développée.

4. Procédé selon l'une quelconque des revendications 1 à 3, caractérisé en ce que le côté opposé au rayonnement est isolé thermiquement.

5. Procédé selon l'une quelconque des revendications 1 à 4, caractérisé en ce que la capacité d'absorption de la couche exposée et développée, pour un rayonnement infrarouge est augmentée par addition d'un adjuvant d'absorption.